# EUROPÄISCHE PATENTSCHRIFT

(11) **EP 1 055 356 B1**
(45) Veröffentlichungstag und Bekanntmachung des Hinweises auf die Patenterteilung: **16.01.2002**
(21) Anmeldenummer: 98962191.7
(22) Anmeldetag: 24.10.1998
(51) Int. Cl.: H05K 9/00, F16J 15/14

(54) **GEHÄUSE**
HOUSING
BOITIER

(30) Priorität: 09.02.1998 DE 19804861
(43) Veröffentlichungstag der Anmeldung: 29.11.2000
(73) Patentinhaber: Kahl, Helmut, 12307 Berlin (DE); Tiburtius, Bernd, 14532 Kleinmachnow (DE)
(72) Erfinder: Kahl, Helmut, 12307 Berlin (DE); Tiburtius, Bernd, 14532 Kleinmachnow (DE)
(74) Vertreter: Eisenführ, Günther, Dipl.-Ing.
(86) Internationale Anmeldenummer: DE9803167
(87) Internationale Veröffentlichungsnummer: WO9940769

(56) Entgegenhaltungen:
- WO-A-98/06246
- US-A- 5 641 438

## Beschreibung

Die Erfindung betrifft ein Gehäuse gemäß dem Oberbegriff des Anspruchs 1.

Ein derartiges Gehäuse ist aus DE 43 19 965 C2 bekannt.

Gehäuse dieser Art werden seit Einsetzen der massenhaften Verbreitung von Mobiltelefonen oder schnurlosen Telefonen aus Kosten- und Gewichtsgründen vorrangig aus Kunststoff gefertigt. Die vorgefertigten, insbesondere spritzgegossenen, Gehäuseteile werden zur Realisierung einer elektromagnetischen Abschirmwirkung mit einem leitfähigen Material beschichtet, etwa durch Aufspritzen von Leitlack, Bedampfen mit Aluminium oder Galvanisieren. Anschließend wird eine ebenfalls abschirmend wirkende Dichtung aufdispensiert, und nach Einsetzen der elektronischen Funktionsgruppen werden die Gehäuseteile miteinander verbunden, in der Regel verschraubt.

Die Abschirmdichtung besteht aus einem elektrisch leitfähigen und elastischen Material und muß in ihren geometrischen Abmessungen und mechanischen Eigenschaften so ausgeführt sein, daß sie sich an Oberflächentoleranzen und - Unebenheiten anpaßt, damit auch bei den in einer Großserienfertigung gegebenen Toleranzen eine sehr hohe Qualität der Abschirmung des Gehäuseinneren gewährleistet ist.

Insbesondere die Anfänge, Enden und Verzweigungen der Dichtungen werfen aufgrund der Addition der Systemtoleranzen Probleme auf. Diese ergeben sich aus Toleranzen des Teiles (Herstelltoleranzen beim Fräsen, Abspritzen oder sonstigen spannenden oder formenden Verfahren) sowie der Einwirkung nachfolgender Behandlungen (Herstellen von galvanischen, mechanisch aufgebrachten oder aufgespritzten Überzügen) oder sonstiger Einwirkungen, etwa von Druck, Strahlung, Wärme, chemischen Lösungs- oder Benetzungsmitteln etc. Die Herstellung der Dichtprofile mit definierter Höhe mit relativ geringer Toleranz wird dabei um so kritischer, je miniaturisierter das System ist. Auch die Erzielung einer ausreichenden Haftung (Scherfestigkeit) gestaltet sich angesichts der Addition der Toleranzen und Störeinflüsse bei miniaturisierten Systemen immer schwieriger.

Das wird an folgendem deutlich: Das Dispensaustrittsglied (z.B. eine Hohlnadel) soll mit definiert geringem Abstand (z.B. 0,6 mm) über der Oberfläche eines Gehäuseteiles geführt werden. Pro 0,1 mm Maßabweichung des Gehäuseteils ändert sich der Abstand um 16 %. Entsprechend mehr Dispensmaterial müßte auf die Oberfläche ausgegeben werden, um eine konstante Höhe des Teilsystems Gehäuseteil-Dichtprofil zu erreichen. Dies könnte über eine aufwendige Meß- und Regeleinrichtung realisiert werden, eine solche Lösung ist jedoch in der Massenfertigung sowohl technisch als auch zeitlich nicht praktikabel.

Die Probleme verschärfen sich bei sogenannten Vielkopfanlagen mit mehreren Dispensaustrittsgliedern, die parallel in mehreren Nestern arbeiten, die toleranzbehaftete Reaktionszeiten aufweisen und zueinander abgestimmt arbeiten müssen.

Stand der Technik ist daher, die Anlagen mit einer Übermenge Material zu betreiben, wobei insbesondere an den Start-, End- oder Verbindungs- bzw. Verzweigungspunkten ein Materialüberschuß eingestellt wird. Die so erzeugten Dichtprofile müssen häufig in arbeits- und damit kostenaufwendiger Weise nachbearbeitet werden.

Der Erfindung liegt deshalb die Aufgabe zugrunde, ein Gehäuse der genannten Art anzugeben, das bei Einhaltung der großserienüblichen Toleranzanforderungen einfacher und kostengünstiger hergestellt werden kann.

Die Aufgabe wird durch ein Gehäuse mit den Merkmalen des Anspruchs 1 gelöst.

Die Erfindung schließt die technische Lehre ein, am Gehäuse als integrierten Bestandteil des Dichtsystems einen Auffangbereich für eine Sicherheits-Übermenge des Dichtungsmaterials vorzusehen. Dies ermöglicht eine Erhöhung der zulässigen Toleranzen der Gehäuseteile wie auch der Steuerung der Dispensköpfe und/oder die Eliminierung etwaiger Nacharbeiten am ausgehärteten Dichtprofil.

Besondere Kostenvorteile erbringt die Erfindung, wenn das erste und/oder zweite Gehäuseteil ein Guß- oder Spritzgußteil, insbesondere aus Kunststoff, mit den bei diesen üblichen großen Toleranzen ist - vor allem wenn die als Auffangbereich dienende Ausnehmung im ersten Gehäuseteil sogleich beim Gießen oder Spritzgießen mitgebildet wird.

Dieser Auffangbereich kann - je nach konkreter Gehäusespezifikation - sowohl in Ausrichtung mit der Längserstrekkung des Dichtprofils als auch diesem gegenüber seitlich versetzt angeordnet sein. Er kann seitlich offen oder rundum geschlossen (z.B. eine offene oder geschlossene Bohrung) sein. Im Auffangbereich verläuft die Dichtungs"raupe" in bestimmten Anwendungsfällen bevorzugt unter einem Winkel zur Richtung der weiteren Erstreckung des Profils.

An der Ausnehmung ist in vorteilhaften Ausführungen eine Schräge oder Kante vorgesehen, um einen verbesserten Eingriff des Dichtstoffstranges mit der Ausnehmung während des Auftrages (ggfs. eine Art Verhaken) zu erreichen und einem eventuellen "Wegrutschen" des Startpunktes entgegenzuwirken, das bei bestimmten Gehäuse-Dichtung-Materialpaarungen bzw. bei verunreinigter Oberfläche vorkommen kann.

Weiterhin kann die Ausnehmung zusammenhängend mit einer zur Aufnahme eines Verbindungsmittels zur Verbindung des ersten und zweiten Gehäuseteils vorgesehenen Öffnung gebildet sein. Diese Konfiguration kann zugleich in vorteilhafter Weise zu einer zusätzlichen Abdichtung in diesen Bereichen genutzt werden.

In einer weiteren vorteilhaften Ausführung ist die Ausnehmung unmittelbar benachbart zu einem an der Oberfläche des ersten Gehäuseteils zum zweiten Gehäuseteil hin hervorstehenden inkompressiblen Abstandshalter angeordnet. Dieser wird zweckmäßigerweise bei der Primärformung des Gehäuseteils aus dem Gehäusematerial gebildet.

Als derzeit praktisch wichtigste Ausführung wird diejenige mit einem EMI-Abschirm- und Dichtprofil, das einen elektrisch leitfähigen Dichtstoff aufweist, und mit Gehäuseteilen aus Kunststoff mit im wesentlichen vollflächiger leitfähiger Beschichtung der mit dem Dichtprofil in Kontakt stehenden Oberfläche angesehen. Die Erfindung ist jedoch auf solche abschirmenden Gehäuse nicht beschränkt, sondern kann vorteilhaft auch bei staub- oder wasserdichten Gehäusen angewandt werden.

Vorteilhafte Weiterbildungen der Erfindung sind im übrigen in den Unteransprüchen gekennzeichnet bzw. werden nachstehend zusammen mit der Beschreibung bevorzugter Ausführungen anhand der Figuren näher dargestellt. Es zeigen:
- Figur 1: eine Prinzipdarstellung zur Ausführung der Erfindung,
- Figur 1a: eine Detaildarstellung aus Fig. 1,
- die Figuren 2a bis 2f: schematische Darstellungen verschiedener Beispiele von Gehäuseabschnitten mit Ausnehmungen im Längsschnitt bzw. in der Draufsicht,
- die Figuren 3a bis 3i: schematische Darstellungen drei er weiterer Ausführungsformen, jeweils in einer Draufsicht und einer Querschnittsdarstellung eines Gehäuseabschnitts sowie im Zustand mit aufgetragenem Dichtstoff-Doppelstrang und
- die Figuren 4a und 4b: schematische Darstellungen zweier weiterer Ausführungsformen der Erfindung.

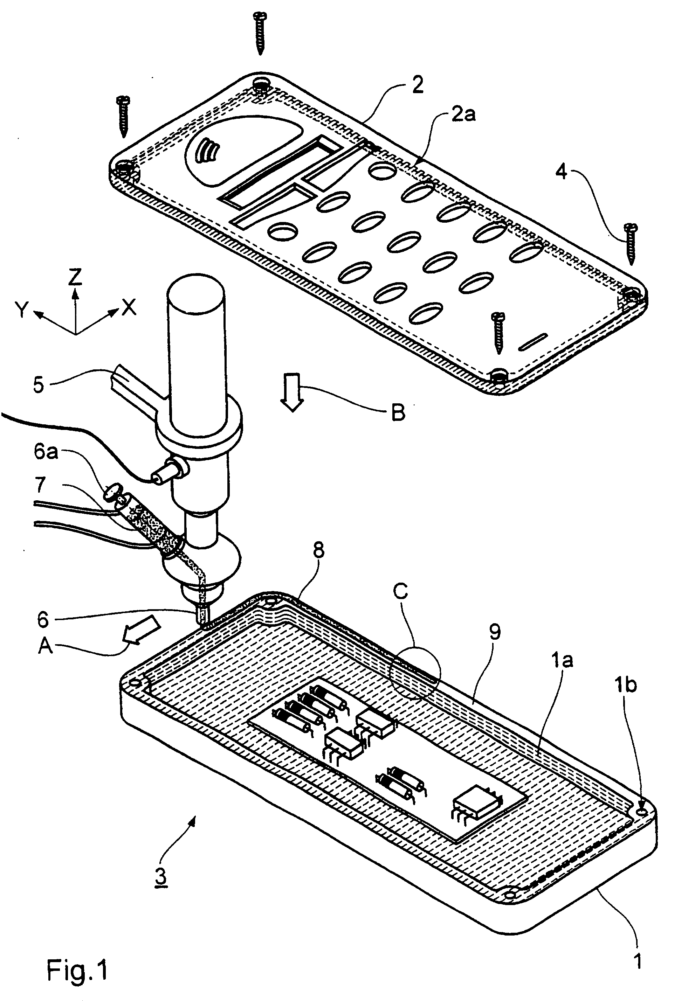

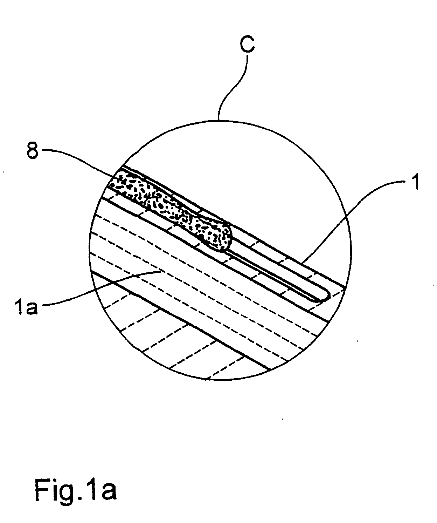

Fig. 1 zeigt schematisch ein Gehäuseunterteil 1 und ein Gehäuseoberteil 2 eines Mobiltelefongehäuses 3 aus spritzgegossenem Kunststoff, die beide mit einer innenseitigen Metallisierungsschicht 1a bzw. 2a versehen sind. In beide Gehäuseteile 1, 2 sind Schraubenlöcher 1b bzw. 2b eingeformt, wobei die Schraubenlöcher 1b im Gehäuseunterteil zum partiell selbstschneidenden Eindrehen von Gewindeschneidschrauben 4 ausgebildet sind.

In der Figur ist skizziert, wie ein Arm 5 einer (nicht insgesamt dargestellten) koordinatengesteuerten Handhabevorrichtung eine Auftragnadel 6 mit einem Schlauchanschluß 6a zur Zuführung eines unter Druck stehenden leitfähigen Dichtungs-Ausgangsmaterials 7 in Richtung des Pfeils A über den Kantenabschnitt des Gehäuseunterteils 1 führt. Dabei wird ein Dicht- und Abschirmmaterialstrang 8 auf den Kantenabschnitt aufdispensiert und haftet dort beim Erhärten fest an. Nachdem die Aushärtung zumindest im wesentlichen abgeschlossen ist, wird - wie mit dem Pfeil B symbolisiert - das Oberteil 2 auf das Unterteil 1 aufgesetzt und über die Schrauben 3 mit diesem verschraubt, wobei der zum Dicht- und Abschirmprofil 8 verfestigte Strang ohne Anhaften am Oberteil 2 elastisch verformt wird und den Spalt zwischen den Gehäuseteilen 1, 2 zuverlässig abdichtet und elektromagnetisch abschirmt.

Im Abschnitt C des Kantenbereiches des Gehäuseunterteils 1 ist eine Ausnehmung 9 in Form eines Langloches eingearbeitet, die in der vergrößerten Darstellung des Abschnitts A in Fig. 1a genauer zu erkennen ist. Das Langloch 9 definiert den Start- und zugleich den Endpunkt bei der Aufbringung des Abschirmprofils 8, an denen zur Gewährleistung einer sicheren Rundum-Abdichtung jeweils eine erhöhte Materialmenge aus der Auftragnadel 5 ausgegeben und zum Teil im Langloch aufgenommen wird.

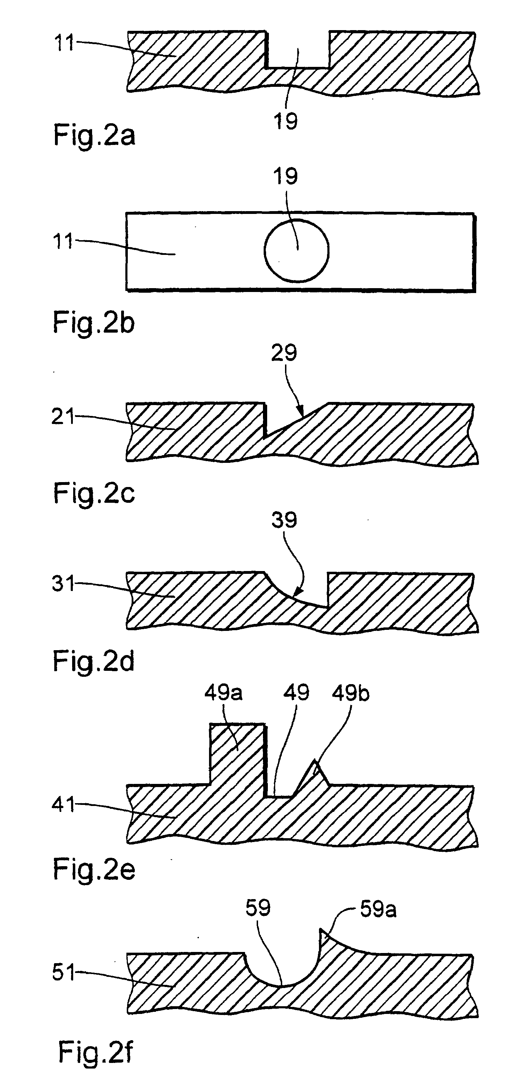

Fig. 2a bis 2f zeigen in schematischen Darstellungen Beispiele von Gehäuseabschnitten von Gehäuseteilen 11, 21, 31, 41 bzw. 51 mit als Auffangbereiche vorgesehenen Ausnehmungen 19, 29, 39, 49 bzw. 59 im Längsschnitt (Fig. 2a und 2c bis 2e) bzw. in einer Draufsicht (Fig 2b als Draufsicht zu Fig 2a). Wie hier zu erkennen ist, kann die Ausnehmung in Abhängigkeit von den konkreten technologischen Randbedingungen als einfache Sackbohrung mit zur Gehäuseteiloberfläche parallelem Boden (Fig. 2a und 2b) oder als Öffnung mit ebenfalls kreisförmigem Querschnitt, aber in verschiedene Richtungen geneigtem oder auch gewölbtem Boden (Fig. 2c bzw. 2d) ausgeführt sein. Weiterhin können ihr eine oder mehrere Erhebung(en) auf der Gehäuseoberfläche zugeordnet sein, wie der dem Auffangbereich 49 in Fig. 2e zugeordnete Abstandshalter 49a und die Schräge 49b oder der einer halbkugeligen Mulde 59 im Gehäuseteil 51 zugeordnete Festhaltegrat 59a. Außer der Funktion einer Abstandhaltung und Begrenzung des sogenannten compressionset (siehe dazu auch die nachfolgenden Ausführungen) haben solche Erhebungen die Funktion einer Haftverbesserung speziell am Startpunkt eines Dichtstoffstranges, insbesondere bei problematischen Oberflächenbeschaffenheiten und/oder Materialpaarungen Gehäuse/Dichtstoff. Auch eine scharfkantige Ausführung des Randes der Ausnehmung selbst kann bis zu einem gewissen Grade diesen Zweck erfüllen.

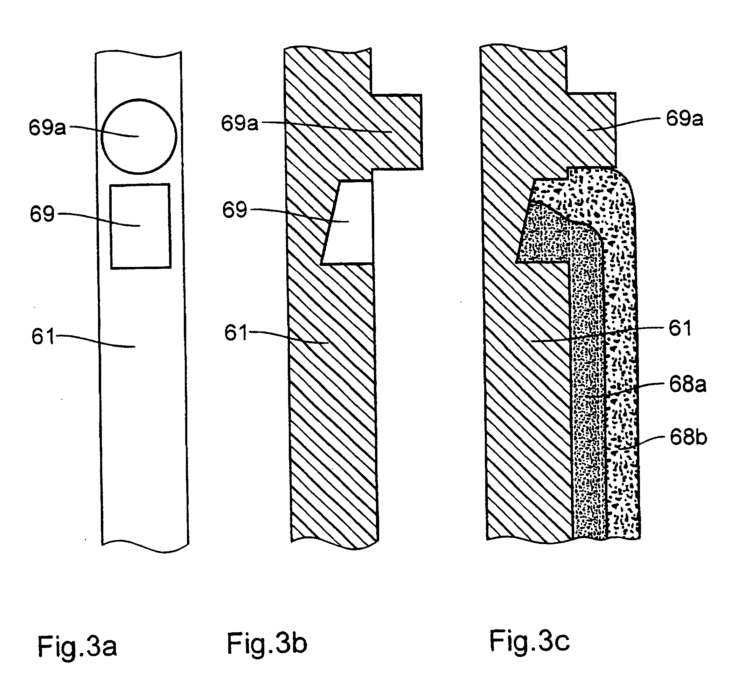

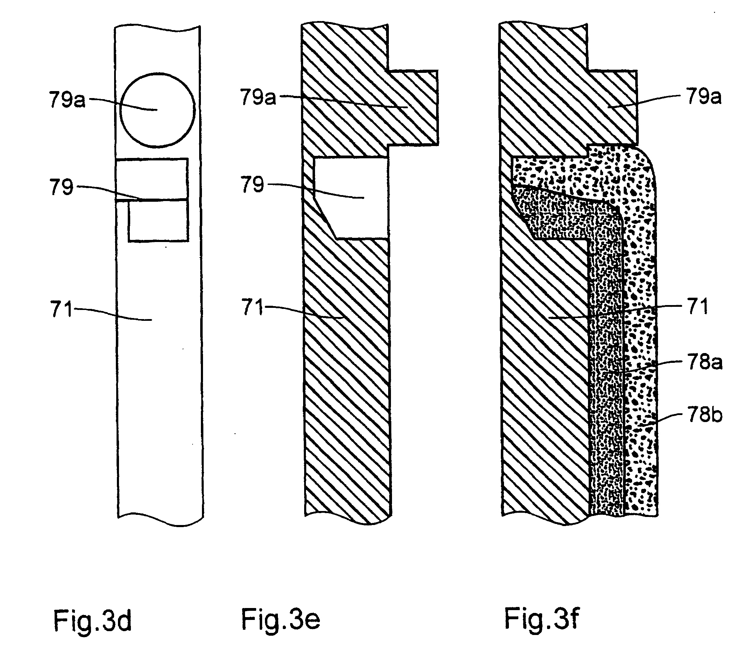

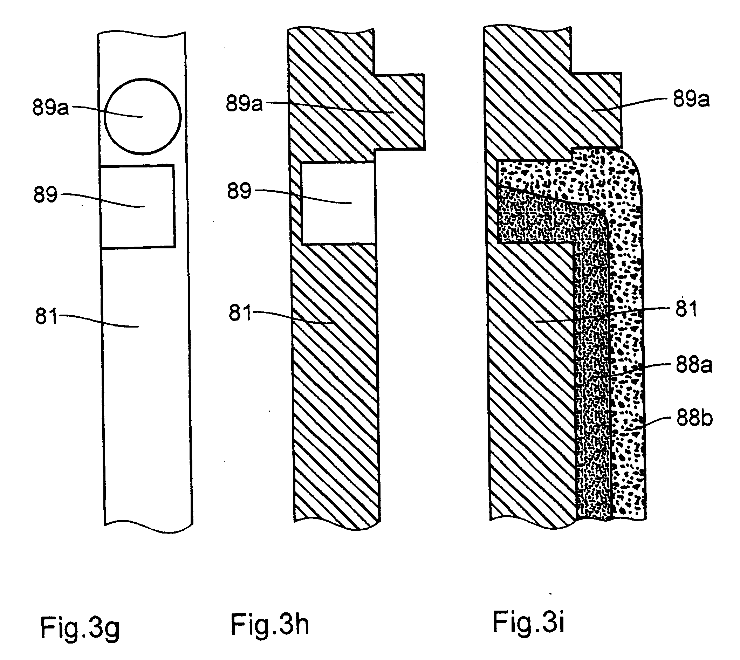

In Fig. 3a bis 3i sind schematisch drei weitere Ausführungsbeispiele gezeigt, jeweils in einer Draufsicht (Fig. 3a, 3d und 3g) und einer Querschnittsdarstellung (Fig. 3b, 3e und 3h) eines Gehäuseabschnitts 61, 71 bzw. 81 sowie im Zustand mit aufgetragenem Dichtstoff-Doppelstrang 68a/68b, 78a/78b bzw. 88a/88b (Fig 3c, 3f und 3i). Die Ausnehmungen 69, 79 und 89 haben hier im wesentlichen rechteckigen Querschnitt, wobei die Ausnehmung 89 eine vollständig offene Seitenfläche und die Ausnehmung 79 einen geöffneten seitlichen Zugang hat, so daß bei den entsprechenden Gehäuseteilen 81 bzw. 71 ein von der geöffneten Seite her in den vorgesehenen Dichtungsverlauf einschwenkender (oder aus diesem ausschwenkender) Dichtstoffauftrag erfolgen kann, bei dem der Start- oder Endpunkt also gegenüber der Längserstreckung des Dichtprofils versetzt ist.

In den Figuren ist der Boden der Ausnehmung 79 im Bereich ihrer seitlichen Öffnung und der Boden der Ausnehmung 89 vollständig eben dargestellt; in modifizierten Ausführungen kann er aber auch zur geöffneten Seite hin ansteigend ausgebildet sein, um ein Ablaufen des noch nicht ausgehärteten Dichtstoffs zu verhindern, falls ein Dichtstoff mit relativ niedriger Viskosität eingesetzt werden sollte.

Der in den Figuren 3a bis 3i gezeigte Abstandhalter (Ziffern 69a, 79a bzw. 89a) hat eine Höhe von ca. 80% der vorgesehenen Höhe des Dichtprofils, um desen Kompression beim Schließen des Gehäuses entsprechend zu begrenzen; die Wahl dieses Verhältnisses ist aber vom konkreten Anwendungsfall, insbesondere der Elastizität und Härte des Dichtprofils, abhängig.

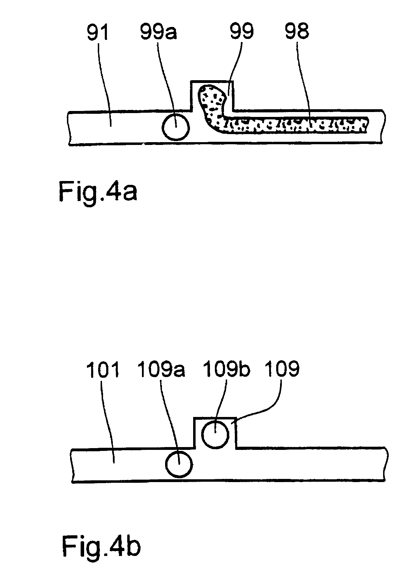

In Fig. 4a und 4b sind in Draufsichten schematisch zwei weitere Ausführungsformen des Auffangbereiches dargestellt. Fig. 4a zeigt eine an ein Gehäuseteil 91 in Nachbarschaft zu einem Abstandhalter 99a seitlich angeformte und gegnüber der Gehäuseoberfläche etwas abgesenkte Ablagefläche 99, die den Startpunkt für den Auftrag eines Dichtprofils 98 bildet, und Fig. 4b eine ähnliche Ausführung, wo die Ablagefläche 109 aber niveaugleich an die Oberfläche des Gehäuseteils 101 angeformt ist und zusätzlich eine Reservoir-Mulde 109b aufweist.

Ein Auffangbereich mit der beschriebenen Funktion der Vergleichmäßigung der Profilhöhe und damit der Dicht- und Abschirmwirkung über den Gehäusekantenverlauf kann in verschiedensten Formen ausgeführt und insbesondere auch an Dichtprofil-Verzweigungspunkten vorgesehen sein.

Bei seiner konkreten Ausformung und Dimensionierung sind neben der im Ansatzbereich des Dispensvorganges zu erwartenden bzw. vorgesehenen Querschnittsvergrößerung des Profilstranges auch die Materialeigenschaften der Dicht- und Abschirmmasse sowohl im pastösen Ausgangszustand (insbesondere ihre Verlaufseigenschaften auf der Gehäuseoberfläche) als auch im Endzustand (insbesondere die Kompressibilität und Elastizität) in Rechnung zu stellen, um den letztlich entscheidenden Funktionsaspekt einer gleichmäßigen Dicht- und Abschirmwirkung über den Gesamtverlauf der abzudichtenden Gehäusebereiche zu realisieren.

## Patentansprüche

1. Gehäuse (3), insbesondere zur elektromagnetisch abgeschirmten Aufnahme von elektronischen Komponenten, mit einem ersten und einem zweiten Gehäuseteil (1, 2) und einem zwischen dem ersten und zweiten Gehäuseteil angeordneten und den Gehäuseinnenraum abdichtenden Dichtprofil (8) aus einem auf das erste Gehäuseteil in pastösem Ausgangszustand aufdispensierten oder aus einem flüssigen Ausgangszustand aufgeschäumten und an diesem unter festem Anhaften elastisch ausgehärteten Dichtstoff (7),
**dadurch gekennzeichnet, daß**
das erste Gehäuseteil im Bereich eines gegenüber dem übrigen Verlauf des Dichtprofils mit erhöhtem Querschnitt ausgeführten Anfangs-, End- oder Verzweigungspunktes des Dichtprofils einen derart ausgebildeten Auffangbereich (9), insbesondere eine Ausnehmung, zur Aufnahme eines Teils des Dichtstoffs aufweist, daß die Höhe des Dichtprofils über dem ersten Gehäuseteil dort etwa die gleiche wie im übrigen Verlauf ist.

2. Gehäuse nach Anspruch 1, **gekennzeichnet durch** ein EMI-Abschirm- und Dichtprofil (8), das einen elektrisch leitfähigen Dichtstoff aufweist.

3. Gehäuse nach Anspruch 1 oder 2, **dadurch gekennzeichnet, daß** das erste und/oder zweite Gehäuseteil (1, 2) ein Guß- oder Spritzgußteil, insbesondere aus Kunststoff und mit im wesentlichen vollflächiger leitfähiger Beschichtung (1a, 2a) der mit dem Dichtprofil (8) in Kontakt stehenden Oberfläche, ist.

4. Gehäuse nach Anspruch 3, **dadurch gekennzeichnet, daß** der Auffangbereich (9) am ersten Gehäuseteil (1) im Gieß- oder Spritzgießschritt zu dessen Primärformung gebildet ist.

5. Gehäuse nach einem der vorhergehenden Ansprüche, **dadurch gekennzeichnet, daß** der Auffangbereich (49 bis 109) unmittelbar benachbart zu einem an der Oberfläche des ersten Gehäuseteils (41 bis 101) zum zweiten Gehäuseteil hin hervorstehenden inkompressiblen Abstandhalter (49a bis 109a) angeordnet ist.

6. Gehäuse nach einem der vorhergehenden Ansprüche, **dadurch gekennzeichnet, daß** der Start- oder Endpunkt des Dichtprofils (78a/78b; 88a/88b, 98) und entsprechend mindestens ein Abschnitt des Auffangbereichs (79; 89; 99; 109) gegenüber dem übrigen Verlauf des Dichtprofils seitlich versetzt angeordnet ist.

7. Gehäuse nach einem der vorhergehenden Ansprüche, **dadurch gekennzeichnet, daß** der Auffangbereich (29; 39; 69; 79) eine gegenüber der Oberfläche des ersten Gehäuseteils (21; 31; 61; 71) geneigte Fläche aufweist.

8. Gehäuse nach einem der vorhergehenden Ansprüche, **dadurch gekennzeichnet, daß** der Auffangbereich zusammenhängend mit einer zur Aufnahme eines Verbindungsmittels zur Verbindung des ersten und zweiten Gehäuseteils vorgesehenen Öffnung gebildet ist.

9. Gehäuse nach einem der vorhergehenden Ansprüche, **dadurch gekennzeichnet, daß** dem Auffangbereich (49; 59) in Richtung des Dichtstoffauftrages eine Festhaltekante (49b; 59a) zur Verbesserung der Haftung des Dichtstoffes auf der Oberfläche des ersten Gehäuseteils (41; 51) an einem Startpunkt zugeordnet ist.

## Claims

1. A housing (3), in particular for the electromagnetically insulated location of electronic components, with a first and a second housing part (1, 2) and a sealing profile (8) disposed between the first and second housing parts and sealing off the interior of the housing, said sealing profile being made from a sealing material (7) applied to the first housing part in the pasty initial state or foamed from a liquid initial state and elastically hardened thereon accompanied by tight adhesion,
**characterised in that,** in the region of an initial, final or bifurcation point of the sealing material which is designed with an enlarged cross section in relation to the remaining length of the sealing profile, the first housing part comprises a receiving area (9), in particular a recess, for housing a part of the sealing material, which receiving area is constructed in such a manner that the height of the sealing profile over the first housing part is roughly the same there as in the remaining length.

2. A housing according to Claim 1,
**characterised by** an EMI screening and sealing profile comprising an electrically conductive sealing material.

3. A housing according to Claim 1 or 2,
**characterised in that** the first and/or second sealing part (1, 2) is a casting or injection moulded part, in particular made from plastic material and having a substantially all-over conductive coating (1a, 2a) of the surface in contact with the sealing profile (8).

4. A housing according to Claim 3,
**characterised in that** the receiving area (9) is formed on the first housing part (1) in the casting or injection moulding stage for its primary shaping.

5. A housing according to one of the preceding Claims,
**characterised in that** the receiving area (49 to 109) is disposed directly adjacent to an incompressible spacer (49a to 109a) which protrudes on the surface of the first housing part (41 to 101) towards the second housing part.

6. A housing according to one of the preceding Claims,
**characterised in that** the initial or final point of the sealing profile (78a/78b; 88a/88b, 98) and accordingly at least one portion of the receiving area (79; 89; 99; 109) is disposed laterally offset with respect to the remaining path of the sealing profile.

7. A housing according to one of the preceding Claims,
**characterised in that** the receiving area (29; 39; 69; 79) comprises a face inclined with respect to the surface of the first housing part (21; 31; 61; 71).

8. A housing according to one of the preceding Claims,
**characterised in that** the receiving area is formed coherently with an aperture provided to receive a connecting means for connecting the first and second housing parts.

9. A housing according to one of the preceding Claims,
**characterised in that** a retention edge (49b; 59a) for improving the adhesion of the sealing material on the surface of the first housing part (41; 51) at an initial point is associated with the receiving area (49; 59) in the direction of the application of the sealing material.

## Revendications

1. Boîtier (3), en particulier à protection électromagnétique, destiné à recevoir des composants électroniques, comprenant une première et une deuxième partie de boîtier (1, 2) et une partie profilée d'étanchéité (8), disposée entre la première et la deuxième partie de boîtier et destinée à rendre étanche le volume intérieur du boîtier, laquelle est réalisée dans un matériau d'étanchéité (7) déposé sur la première partie de boîtier sous forme dispersée à l'état initial pâteux ou sous forme expansée à l'état initial liquide et durci souplement contre celle-ci par forte adhérence, **caractérisé en ce que** la première partie de boîtier dans la zone d'un point d'origine, point final ou point de déviation de la partie profilée d'étanchéité, exécuté avec une plus grande section que le tracé restant de la partie profilée d'étanchéité, comporte une zone réceptrice, en particulier un évidement, destinée à recevoir une partie du matériau d'étanchéité et conçue de manière telle que la hauteur de la partie d'étanchéité profilée au-dessus de la première partie de boîtier est pratiquement identique à celle du reste du tracé.

2. Boîtier selon la revendication 1, **caractérisé par** une partie profilée (8) d'étanchéité et de protection EMI, qui est formée par un matériau d'étanchéité électro-conducteur.

3. Boîtier selon la revendication 1 ou 2, **caractérisé en ce que** la première et/ou la deuxième partie de boîtier (1, 2) sont formées par une pièce moulée ou une pièce moulée par injection, en particulier en matière plastique et avec un revêtement (1a, 2a) conducteur déposé sensiblement sur toute la face de la surface en contact avec la partie profilée d'étanchéité (8).

4. Boîtier selon la revendication 3, **caractérisé en ce que** la zone réceptrice (9) sur la première partie de boîtier (1) est réalisée au cours de l'étape de moulage ou de moulage par injection de la forme primaire de ladite première partie de boîtier.

5. Boîtier selon l'une des revendications précédentes, **caractérisé en ce que** la zone réceptrice (49 à 109) est disposée directement à proximité d'un écarteur (49a à 109a) incompressible, en saillie sur la surface de la première partie de boîtier (41 à 101) et orienté vers la deuxième parties de boîtier.

6. Boîtier selon l'une des revendications précédentes, **caractérisé en ce que** le point d'origine et le point final de la partie profilée d'étanchéité (78a/78b ; 88a/88b, 98) et, de manière correspondante, au moins une partie de la zone réceptrice (79 ; 89 ; 99 ; 109) sont décalés latéralement par rapport au reste du tracé de la partie profilée d'étanchéité.

7. Boîtier selon l'une des revendications précédentes, **caractérisé en ce que** la zone réceptrice (29 ; 39 ; 69 ; 79) comporte une surface inclinée par rapport à la surface de la première partie de boîtier (21 ; 31 ; 61 ; 71).

8. Boîtier selon l'une des revendications précédentes, **caractérisé en ce que** la zone réceptrice est formée de façon communicante avec un orifice prévu pour recevoir un moyen d'assemblage destiné à assembler la première et la deuxième partie de boîtier.

9. Boîtier selon l'une des revendications précédentes, **caractérisé en ce qu'**un bord de retenue (49b ; 59a), destiné à améliorer l'adhérence du matériau d'étanchéité sur la surface de la première partie de boîtier (41 ; 51), est associé en un point d'origine à la zone réceptrice (49 ; 59) en direction du dépôt du matériau d'étanchéité.
